# EUROPÄISCHE PATENTSCHRIFT

(11) **EP 0 600 052 B1**
(45) Veröffentlichungstag und Bekanntmachung des Hinweises auf die Patenterteilung: **17.04.1996**
(21) Anmeldenummer: 93909756.4
(22) Anmeldetag: 10.06.1993
(51) Int. Cl.: H05K 3/40

(54) **VERFAHREN ZUR HERSTELLUNG VON NACHTRÄGLICH KONDITIONIERBAREN KONTAKTSTELLEN AN SCHALTUNGSTRÄGERN UND SCHALTUNGSTRÄGER MIT SOLCHEN KONTAKTSTELLEN**
PROCESS FOR PRODUCING SUBSEQUENTLY CONDITIONABLE CONTACT POINTS ON CIRCUIT SUBSTRATES AND CIRCUIT SUBSTRATES WITH SUCH CONTACT POINTS
PROCEDE POUR LA PRODUCTION DE POINTS DE CONTACT ULTERIEUREMENT CONDITIONNABLES SUR DES SUPPORTS DE CIRCUIT, AINSI QUE SUPPORTS DE CIRCUIT POURVUS DE TELS POINTS DE CONTACT.

(30) Priorität: 15.06.1992 CH 1875/92; 15.06.1992 CH 1876/92; 15.06.1992 GB 9212648
(43) Veröffentlichungstag der Anmeldung: 08.06.1994
(73) Patentinhaber: DYCONEX PATENTE AG, Ch-6300 Zug (CH)
(72) Erfinder: SCHMIDT, Walter, CH-8050 Zürich (CH); MARTINELLI, Marco, CH-8413 Neftenbach (CH)
(74) Vertreter: Frei, Alexandra Sarah
(86) Internationale Anmeldenummer: CH9300147
(87) Internationale Veröffentlichungsnummer: WO9326144

(56) Entgegenhaltungen:
- FR-A- 2 480 554
- GB-A- 1 134 632
- US-A- 3 098 951
- US-A- 3 346 950
- US-A- 4 064 357
- US-A- 4 319 708
- US-A- 4 517 050

## Beschreibung

Die Erfindung liegt auf dem Gebiete der Herstellung von Schaltungsträgern und betrifft ein Verfahren gemäss dem Oberbegriff des ersten, unabhängigen Patentanspruchs zur Herstellung von nachträglich konditionierbaren Kontaktstellen an Schaltungsträgern, sowie Schaltungsträger mit derartigen Kontaktstellen nach dem Oberbegriff des entsprechenden, unabhängigen Patentanspruchs. Nachträglich konditionierbare Kontaktstellen sind Stellen in einem beliebigen Layout von Leiterbahnen, an welchen zwei Leiterbahnen bei Bedarf nach der Herstellung des Schaltungsträgers kontaktiert, das heisst elektrisch leitend miteinander verbunden werden können.

In der Schrift US-4,517,050 wird Verfahren zum Erzeugen von elektrisch leitenden Verbindungen in Schaltungsträgern offenbart, wo ein Dielektrikum zwischen zwei Lagen leitfähigen Materials angeordnet ist und wo in das Dielektrikum nichtkreisförmige Oeffnungen durch Unterätzen eingebracht werden, sodass die beiden Lagen leitfähigen Materials durch Deformation miteinander in Kontakt gebracht werden.

Die Erfindung stellt sich die Aufgabe, auf Schaltungsträgern nachträglich konditionierbare Kontaktstellen herzustellen, derart, dass vorgegebene Layouts durch nachträglich erstellbare, elektrische Verbindungen zwischen Leiterbahnen konditioniert werden können. Dadurch soll es möglich werden, in Schaltplänen bzw. auf den Leiterplatten Stellen vorzusehen, welche nachträglich noch kontaktiert werden können, was die Flexibilität von vorgefertigten Schaltungen erhöht. Solche "taktisch verteilte" Nachrüststellen in einer Leiterplatte sind mit der herkömmlichen Layout- und Aetztechnik nicht herstellbar, weil es sich stets um hybridtechnische Vorgänge handelt. Wichtig ist jedoch, dass die Nachkontaktierung adäquat durchgeführt werden kann und die Ermöglichung dieser bemerkenswerten Erweiterung das mit diesen Vorteilen ausgezeichnete Produkt nicht verteuert, mindestens nicht wesentlich.

Diese Erweiterung würde es bspw. ermöglichen, in einer Fabrikationsserie Grundschaltungen mit einer Anzahl Schaltungsvariationen oder -varianten, über die kurzfristig entschieden werden kann, herzustellen. Damit lässt sich die Erfindung in eine kostenoptimierende, flexible computerunterstützte Fabrikation ausbauen.

Das Verfahren zum Herstellen von nachträglich kontaktierbaren Kontaktstellen an einem Schaltungsträger gemäß der Erfindung ist in Anspruch 1 definiert. Ein erfindungsgemäßer Schaltungsträger ist in Anspruch 9 definiert.

Für die Herstellung der erfindungsgemässen konditionierbaren Kontaktstellen wird das Phänomen der unerwünschten Unterätzung verwendet. Das Phänomen der Unterätzung ist bekannt, man versucht stets Unterätzungen zu vermeiden. In der Regel sind sie unerwünscht und tangieren die Produktqualität beträchtlich. Für die Erstellung der erfindungsgemässen Kontaktstellen werden sie zielgerecht herbeigeführt und ausgenützt. Im vorliegenden Erfindungsbeispiel wird ein Plasma-Aetzprozess an einer dünnen, beidseitig metallkaschierten Kunststoffolie verwendet, an der vorgängig beispielsweise durch photochemische und nassätztechnische Prozessschritte entsprechende Fenster in die Metallkaschierung eingebracht wurden. Für die Konditionierung der konditionierbaren Kontaktstellen, das heisst also für die effektive Herstellung eines Kontaktes, wird bei einer von zwei gezeigten, beispielsweisen Ausführungsformen das in der Leiterplattentechnik bekannte Jet-Scrubber Verfahren oder Bimsmehlstrahlen angewendet.

Mit Hilfe der nachfolgend aufgeführten Figuren werden zwei Ausführungsbeispiele gemäss Erfindung diskutiert. Als Aetzverfahren für die Folie wird bevorzugt ein Plasma-Aetzverfahren vorgeschlagen, wobei aber auch Nasstechniken grundsätzlich verwendet werden können. Als Aetzverfahren für die Metallkaschierung, bspw. Kupfermaske, kann ein übliches Verfahren zur Herstellung von Leiterplatten verwendet werden.
- **Figuren 1a und b**: zeigen als Beispiel zwei in die Metallkaschierung geätzte Fenster, die fluchtend auf je einer Seite eines Substrates, beispielsweise einer Kunststoffolie angebracht werden (auch andere Formen mit funktionell korrelierten Kontaktstellen sind möglich, aus der Vielfalt wurde dieses leicht einsehbare Beispiel herausgegriffen);
- **Figur 2**: zeigt im Schnitt schematisch die konditionierbare Kontaktstelle, die durch Durchätzung des Substrates und Unterätzung der beiden Fenster gemäss Figur 1 entsteht;
- **Figur 3**: zeigt die Kontaktstelle gemäss Figur 2, wie sie nachträglich mittels- Druck auf die unteren und/oder oberen Leiterbahnen kontaktiert wird;
- **Figur 4**: zeigt ein weiteres Beispiel für ein Ätzfenster zur Herstellung einer nachträglich konditionierbaren Kontaktstelle;
- **Figur 5**: zeigt schematisch die konditionierbare Kontaktstelle, die durch Unterätzung eines Ätzfensters gemäss Figur 4 und Durchätzen des Substrates entsteht;
- **Figuren 6a und b**: zeigen die Kontaktstelle gemäss den Figuren 4 und 5 nachträglich mittels Jet-Scrubbing kontaktiert (Fig. 6a) und anschliessend mittels eines leitfähigen Fixiermittels fixiert (Fig. 6b);
- **Figur 7**: zeigt in schematischer Darstellung eine beispielhafte Ausführungsform eines Schaltungsträgers mit zwei Leiterbahnenebenen und erfindungsgemässen Kontaktstellen zwischen diesen, wobei die Leiterbahnenmuster und Kontaktstellen derart ausgelegt sind, dass sich der Schaltungsträger für die wahlweise Pinkonversion von elektronischen Bausteinen eignet;
- **Figur 8**: zeigt den Schaltungsträger gemäss Figur 7 im Schnitt zur Sichtbarmachung von bei der nachträglichen Konversion kontaktierten und nicht kontaktierten Kontaktstellen;
- **Figur 9**: zeigt ein Schema der verschachtelten Normraster des Schaltungsträgers gemäss Figuren 7 und 8 mit Pin-Stellen und konditionierbaren Kontaktstellen.

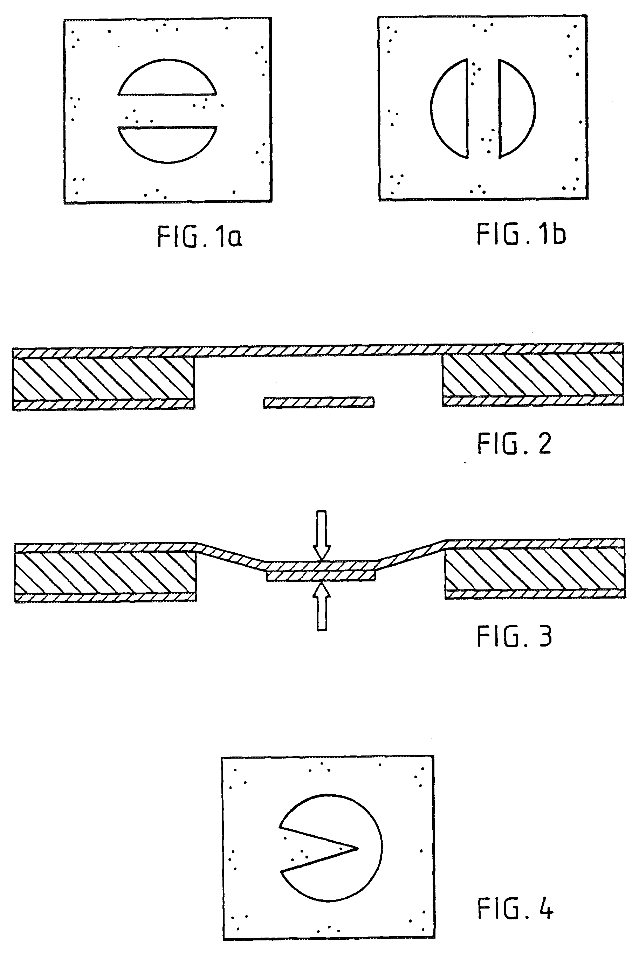

Während Fenster für übliche Durchkontaktierungen durch das Substrat üblicherweise rund oder quadratisch sind, besitzen die entsprechenden Fenster für erfindungsgemässe, konditionierbare Kontaktstellen, wie in den Figuren 1a und b gezeigt, beispielsweise einen, das Fenster überspannenden Steg, wobei die beiden Stege an einander gegenüberliegenden Fenstern nicht gleichgerichtet sind. Diese Stege bleiben beim Durchätzen des Substrates stehen und unterätzt, sodass sie nach dem Ätzschritt über die Öffnungen verlaufende, sich kreuzende Leiterbahnen bilden, die das entstandende Loch überbrücken, wie dies in Figur 2 ersichtlich ist. Bedingt durch die Tatsache, dass das Substrat, wenn es sich um eine Kunststoffolie handelt, beispielsweise nur 12 bis 25 µm dick ist, bedeutet dies, dass sich zwei Kupferleiter ohne dazwischenliegendes festes Dielektrikum im Abstand von 10 - 20 µm überkreuzen, bzw. gegenüberstehen.

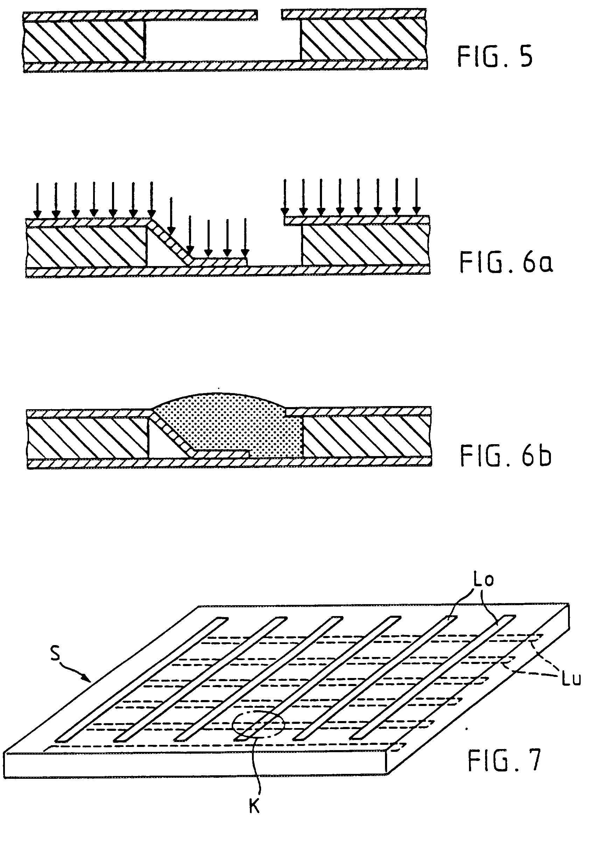

Durch lokalen Druck, wie dies in allgemeiner Form in Figur 3 gezeigt ist, evtl. verbunden mit dem Durchfluss eines schwachen elektrischen Stromes, können die beiden Leiter einer derartigen konditionierbaren Kontaktstelle wahlweise miteinander verschweisst werden. Bei dünnen Folien können solche Kontaktstellen mit einem feinen elastischen Stempel/Gegenstempel schnell und sicher aneinandergedrückt, vereinigt und damit kontaktiert werden. Bei Bedarf kann anschliessend die Kontaktstelle mit einem Klebertupfen fixiert werden. Bei dickeren Folien (über 100 µm) werden die, natürlich im Durchmesser entsprechend verlängerten Leiterbahnen (hier werden aus Platzgründen ovale oder langgezogene rechteckige Formen eines der beiden Fenster empfohlen) mit einem oder zwei gegeneinander wirkenden feinen Stiften (wie in Figur 3 als Kraftpfeile und in Figur 5 als Stift angedeutet) eingedrückt.

Die zweite, beispielhafte Ausführungsform der erfindungsgemässen Kontaktstellen ist weniger leiterplattendickenempfindlich und kann besonders für solch dickere Substrate empfohlen werden.

Fig. 4 zeigt das einseitig anzubringende Ätzfenster für die Herstellung der zweiten Ausführungsform der erfindungsgemässen, nachträglich konditionierbaren Kontaktstelle. Dieses Fenster stellt eine Aussparung dar, in die eine Zunge hineinragt, auf der Gegenseite bleibt die Kaschierung (in Form einer Leiterbahn) erhalten. Nach dem Durchätzen, wodurch eine Art Sackloch durch das Substrat entsteht und die Zunge unterätzt wird, ragt die Zunge ohne ein dazwischenliegendes festes Dielektrikum im Abstand von 10 -200 µm frei über die freiglegte Kaschierung der Gegenseitseite, wie dies in der Figur 5 dargestellt ist. Bei grösseren Dicken wird die Zunge entsprechend länger gemacht.

Die beiden Seiten können mit Hilfe eines Stiftes (Figur 5) oder mit Hilfe von gezieltem Jet-Srubbing (in Figur 6a durch viele kleine Kraftpfeile dargestellt) kontaktiert werden, wobei die Zunge zur Gegenkaschierung hingebogen (Figur 6a) wird. Dann kann durch Einbringen eines elektrisch leitfähigen Klebers bzw. eines nichtausgehärteten Kunststoffs der Kontakt zusätzlich fixiert (Figur 6b) werden. Die elektrische Durchverbindung kann auch ausschliesslich durch Einfüllen von elektrisch leitfähigem Kleber realisiert werden. Dieser drückt die Zunge gegen die Gegenseite, verbindet die beiden Kupferfolien und erzeugt den elektrischen Kontakt. Das Einbringen eines solchen elektrisch leitfähigen Klebers kann durch Druckverfahren wie z.B. Siebdruck erfolgen. Eine weitere Möglichkeit besteht darin, ein elektrostatisches Druckverfahren mit elektrisch leitfähigem Tonersystem zu verwenden. Der Toner wird dabei durch herkömmliche Verfahren der elektrostatischen Drucktechnik in die ausgeätzten Löcher eingedruckt und durch Wärme eingeschmolzen.

An Stelle eines Jet-Scrubbing kann die elektrische Kontaktierung ebenfalls mittels eines Siebdruckverfahrens durchgeführt werden, indem man an den Kontaktstellen, die geschlossen oder durchkontaktiert werden sollen, Lötpaste in die Kontaktstellen eindrückt und die zu verbindenden Seiten anschliessend durch Aufschmelzen der Paste durch Heissluft, IR, Laser, Gasphasen-Lötung oder Kombination dieser Methoden miteinander verlötet.

Es ist leicht einsehbar, dass für die zweite Variante gemäss Figuren 4 bis 6 die Dicke des Substrates weniger ins Gewicht fällt, als beim erstgezeigten Beispiel (Figuren 1 bis 3). Die erste Variante eignet sich insbesondere für bei der Konditionierung beidseitig zugänglicher Kontaktstellen, also an Schaltungsträgern mit im wesentlichen zwei Leiterbahnenebenen, die sich beidseitig eines Substrates befinden. Die zweite Variante eignet sich insbesondere für konditionierbare Kontaktstellen zwischen einer zugänglichen (äusseren) Leiterbahnenlage und einer nicht zugänglichen (inneren) Leiterbahnenlage.

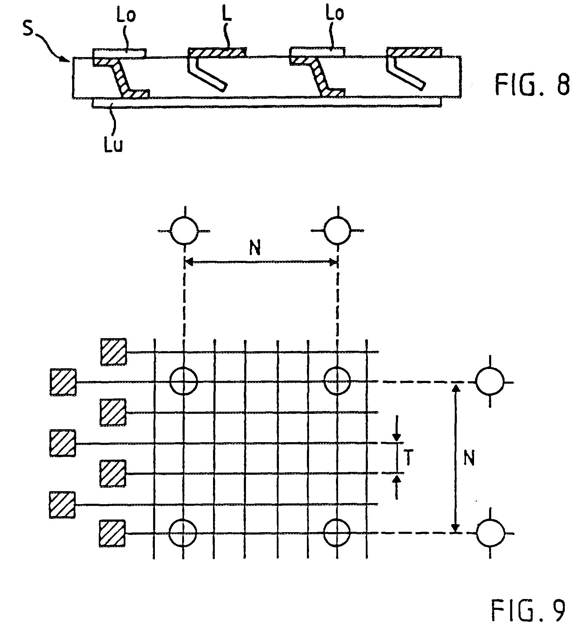

Wie bereits eingangs erwähnt, können die nach dem beschriebenen Verfahren hergestellten, nachträglich konditionierbaren Kontaktstellen in beliebigen Schaltungen vorgesehen sein. **Figuren 7, 8 und 9** zeigen nun eine spezielle Anwendung und zwar auf einem Substrat, das der wahlweisen Konversion der Norm-Pinbelegung von integrierten Schaltungen dient.

Käufliche aktive Bausteine komplexerer Bauart haben in der Regel eine grosse Anzahl von Anschlusskontakten (Pins), die nach einem Norm-Schema angeordnet sind und nach denen sich der gesamte Layout der mit dem Baustein zu bestückenden Leiterplatte zu richten hat. Dies erzeugt schon Sachzwänge, wenn nur ein solcher Baustein auf einer Platine verwendet wird, bspw. ein µ-Prozessor, bei mehreren solchen Bausteinen wird der Sachzwang zunehmend gravierender.

Optimiert man nun einen Layout ohne Rücksicht auf alle benötigten Pins solcher Bausteine, sondern nur auf einen gut ins Layout umsetzbaren Teil davon, dann muss der Baustein bezüglich seiner Pinbelegung so konvertiert werden, dass er in den Layout passt. Man diktiert nun umgekehrt die Pinbelegung von der Leiterplatte auf den Chip. Solche Leiterschnittstellen können bei customisierten Bausteinen entweder im Chipgehäuse untergebracht werden oder im Sockel vorgesehen sein. Die Folientechnik und die erfindungsgemässen konditionierbaren Kontaktstellen eignen sich besonders zur Realisierung solcher Schnittstellen.

Die Folien-Leiterplattentechnik erlaubt es, Schaltungsträger mit zwei Leiterbahnenebenen mit extrem dichten Anlagen von Leitern und konditionierbaren Kontaktstellen zwischen den Leiterebenen herzustellen, sodass es möglich ist, innerhalb des Normrastermasses der Pins eines Chips mehrere Leiterbahnen und Kontaktstellen anzuordnen, sodass im Sockelbereich eine Infrastruktur mit einer grossen Zahl von potentiellen Umleitstellen entsteht, durch welche die Kontakte einer beliebigen Zahl von Pins "verlegt" werden können.

Die Figur 7 zeigt schematisch, wie diese Infrastruktur angelegt ist. Ein Substrat S, in der Regel eine Folienleiterplatte in der ungefähren Grösse des Sockels weist auf der einen Seite (oben) eine Vielzahl paralleler Leiterbahnen auf. Auf der anderen Seite (unten) sind eine gleiche Vielzahl von parallelen Leiterbahnen angeordnet, jedoch zu den oberen gekreuzt. An jeder projizierten Kreuzungsstelle der Leiter ist eine konditionierbare Kontaktstelle K, wie sie im Zusammenhang mit den Figuren 1 bis 6 beschrieben wurde, vorgesehen. An diesen Kontaktstellen lassen sich in einem nachträglichen Konditionierungsschritt wahlweise Kontakte schaffen.

Figur 8 zeigt das Substrat S im Schnitt. Zur eindrücklicheren Darstellung wurden die Kontaktstellen mit aktiven (geschlossenen, siehe Figuren 3 und 6a oder 6b) und passiven (offenen, siehe Figuren 2 und 5) Kontakten rein symbolisch gezeichnet.

Man sieht die Leiteranordnung oben und unten; dazwischen aktive und passive Kontaktstellen. Die Figur 8 zeigt, wie man eine Leiterbahn L überbrückt; nämlich dadurch, dass man den oberen Leiter Lo über einen aktiven Kontakt auf den unteren Leiter Lu leitet und von dort wieder über einen anderen aktiven Kontakt auf einen anderen oberen Leiter Lo. Dazwischen erkennt man offene, passive Kontakte. Bei Bedarf, falls die Schaltungsdichte erhöht werden muss, kann man Leiter, wie bspw. Leiter Lu zwischen zwei Kontakten unterbrechen, bspw. mit einem Laser durchschneiden.

Figur 9 zeigt übersichtshalber die verschachtelte Rasterung. Mit Kreisen ist der Pinraster von normierten Bausteinen mit dem Normabstand N eingezeichnet und mit einem Gitter der Teilraster mit dem Abstand T. Für den Teilraster hat man genügend Freiheitsgrade, um ihn der verwendeten Technologie und zugleich den gestellten Bedürfnissen anzupassen. Auf der linken Seite sind schematisch quadratförmige Anschlussstellen für das Konversionssubstrat an die Umgebung eingezeichnet.

Vorteilhaft ist, dass man Substrate mit den verschachtelten Rastern, in denen die Leiterbahnen verlaufen und welche an den projizierten Schnittstellen mit konditionierbaren Kontaktstellen versehen sind, vorfabrizieren kann. Mittels Plasmaätzen kann man alle Kontaktstellen gleichzeitig herstellen und mittels gezieltem Jet-Scrubbing kann man eine Vielzahl von Kontaktstellen in einem Arbeitsgang konditionieren. In einem Layout-Router wird das Konversionssubstrat rechnerisch "mitgeführt". Der Router probiert, ob er durch Pinbelegungsänderungen Kreuzungsstellen vermeiden kann. Es ist anzunehmen, dass mit dieser Technik die Zahl der "nicht verbindbaren" Kontakte um Faktor 10 abnehmen wird.

## Patentansprüche

1. Verfahren zum Herstellen von nachträglich kontaktierbaren Kontaktstellen (K) zwischen zwei durch eine elektrisch isolierende Schicht, insbesondere eine Kunststoffolie, getrennten Leiterbahnenebenen eines Schaltungsträgers, **gekennzeichnet,** durch die Anlage von Oeffnungen in mindestens einer Leiterbahnenebene derart, dass beim nachfolgenden Durchätzen des Substrates durch Unterätzen stegförmige, mit der Oeffnungsperipherie verbundene Leiterbahnenteile zwischen oder in den Oeffnungen freigelegt werden, wobei die Stege so gerichtet sind, dass sie in der Projektion an den Durchführungen sich kreuzende Leiterbahnen (Lo,Lu) verbinden, wodurch die Stege frei übereinanderliegen und bei Bedarf durch Gegeneinanderführen in elektrischen Kontakt bringbar sind.

2. Verfahren nach Anspruch 1, **dadurch gekennzeichnet,** dass in der einen Leiterbahnenebene mit dem Leiterbild der anderen Leiterbahnenebene korrespondierende Oeffnungen mit einem in die Oeffnung ragenden und der Oeffnungsperipherie verbundenen Leiterbahnenteil angelegt werden, wobei dieser Leiterbahnenteil so gerichtet ist, dass er in der Projektion eine Leiterstelle der anderen Leiterbahnenebene deckt, und dass in einem weiteren Schritt die isolierende Schicht zwischen den beiden Leiterbahnenebenen durch die Öffnung durchgeätzt wird, wodurch der Leiterbahnenteil frei über der korrespondierenden Kontaktstelle liegt und bei Bedarf durch Biegen gegen die Kontaktstelle mit dieser in Kontakt bringbar ist.

3. Verfahren nach Anspruch 1, **dadurch gekennzeichnet,** dass zur Kontaktierung an den Kontaktstellen die sich gegenüberliegenden Leiterbahnenteile mittels eines Stiftes zueinander geführt und elektrisch leitend verbunden werden.

4. Verfahren nach Anspruch 1, **dadurch gekennzeichnet,** dass zur Kontaktierung an den Kontaktstellen der freigelegte Raum zwischen den Stegen mit einem elektrisch leitenden Material aufgefüllt wird.

5. Verfahren nach Anspruch 2, **dadurch gekennzeichnet,** dass zur Kontaktierung an den Kontaktstellen der mit der Oeffnungsperipherie verbundene, in die Oeffnung hineinragende Leiterbahnenteil der Oeffnung mittels Jet-Scrubbing in die Durchführung im Leiterplattensubstrat hineingebogen wird, um mit der Gegenseite des Leiterbildes kontaktiert zu werden.

6. Verfahren nach Anspruch 5, **dadurch gekennzeichnet,** dass der in die Durchführung hineingebogene Leiterbahnenteil mit einem leitfähigen Material fixiert wird.

7. Verfahren nach einem der Ansprüche 4 oder 6, **dadurch gekennzeichnet,** dass das elektrisch leitende Material ein Kleber oder Toner ist.

8. Verfahren nach Anspruch 7, **dadurch gekennzeichnet**, dass das elektrisch leitende Material durch einen Siebdruckprozess in die Kontaktstellen eingebracht wird.

9. Schaltungsträger mit konditionierbaren oder konditionierten Kontaktstellen zum Umleiten von Leitungen aus einem ersten Leitungsraster (N) zu Leitungen in einem anderen Leitungsraster, wobei der Schaltungsträger zwei durch eine elektrisch isolierende Schicht, insbesondere eine Kunststoffolie, voneinander getrennten Leiterbahnenebenen aufweist, **dadurch gekennzeichnet,** dass die elektrisch isolierende Schicht Durchführungen aufweist, dass Leiterbahnen (Lo, Lu) dieser Leiterbahnenebenen sich in der Projektion an den Durchführungen kreuzen, dass Leiterbahnenteile dieser Leiterbahnenebenen beidseitig über diese Durchführungen reichen,dass diese Leiterbahnenteile über diesen Durchführungen mechanisch verformbar und/oder verformt übereinander liegen, dass mechanisch verformte Leiterbahnenteile einer Leiterbahnenebene mit einem Leiterbahnenteil der gegenüberliegenden Leiterbahnenebene elektrisch kontaktierbar oder kontaktiert sind und konditionierbare oder konditionierte Kontaktstellen (K) bilden und dass diese Kontaktstellen einen geteilten Abstand (T) des ersten Leitungsrasters (N) zueinander aufweisen, sodass die Umleitung der Leitungen vom ersten Leitungsraster in Leitungen des anderen Leitungsrasters durch nachträglich erstellbare Kontaktstellen erfolgt.

10. Schaltungsträger nach Anspruch 9, **dadurch gekennzeichnet,** dass der erste Leitungsraster einer ersten Normpinbelegung von integrierten Schaltungen angehört und dass der andere Leitungsraster einer anderen Normpinbelegung von integrierten Schaltungen angehört.

11. Schaltungsträger nach Anspruch 9, dadurch gekennzeichnet, dass die mechanisch verformbaren und/oder verformten Leiterbahnenteile von der Peripherie einer Durchführung ausgehende und in die Durchführung biegbare oder gebogene Leiterbahnenteile sind.

12. Schaltungsträger nach einem der Ansprüche 9 oder 11, dadurch gekennzeichnet, dass die verformten Leiterbahnenteile mit elektrisch leitendem Material in Kontaktstellung fixiert sind.

13. Schaltungsträger nach Anspruch 12, dadurch gekennzeichnet, dass die Kontaktstellen mit Siebdruck eingebrachte elektrisch leitende Materialien aufweisen.

14. Schaltungsträger nach einem der Ansprüche 9 bis 13, **dadurch gekennzeichnet,** dass die beiden Leiterbahnenebenen je eine Anordnung von parallel verlaufenden Leiterbahnen aufweisen, wobei die Leiterbahnen der einen Ebene nicht parallel sind zu den Leiterbahnen der anderen Ebene und mindestens an einem Teil der Kreuzungen der Leiterbahnen der beiden Ebenen konditionierbare oder konditionierte Kontaktstellen angeordnet sind.

15. Schaltungsträger nach Anspruch 14, **dadurch gekennzeichnet,** dass die Leiterbahnanordnung der beiden Leiterbahnenebenen in einem Winkel von 90° zueinander stehen.

## Claims

1. Process for the manufacture of subsequently contactable contact points (K) between two conductor track planes of a circuit carrier separated by an electrically insulating layer, in particular a plastic film, **characterised** by the arrangement of openings in at least one conductor track plane, such that during subsequent etching-through of the substrate by undercutting, bridge-shaped conductor track parts, connected to the periphery of the openings, are exposed between or in the openings, the bridges being so aligned that in projection they connect intersecting conductor tracks (Le, Lw) at the apertures, wherein the bridges lie clear of one another and can as required be brought into electrical contact by guiding them towards one another.

2. Process according to Claim 1, **characterised in that** in one of the conductor track planes are arranged openings corresponding to the printed conductor image of the other conductor track plane having a conductor track part connected to the periphery of the opening and projecting into the opening, wherein the said conductor track part is aligned so that in projection it covers a zone of the conductor of the other conductor track plane, and that in a further step the insulating layer between the two conductor track planes is etched through, through the opening, whereby the conductor track part lies clear above the corresponding contact point and as required can be brought into contact with this by bending towards the contact point.

3. Process according to Claim 1, **characterised in that** for making contact at the contact points the conductor track parts lying opposite each other are guided together by means of a pin and are conductively connected electrically.

4. Process according to Claim 1, **characterised in that** for making contact at the contact points the exposed space between the bridges is filled with an electrically conductive material.

5. Process according to Claim 2, **characterised in that** for making contact at the contact points the conductor track part of the opening, connected to the periphery of the opening, projecting into the opening is bent inwards by means of jet scrubbing into the aperture within the printed circuit board substrate in order to make contact with the opposite side of the printed conductor image.

6. Process according to Claim 5, **characterised in that** the conductor track part bent into the aperture is fixed by a conductive material.

7. Process according to one of Claims 4 or 6, **characterised in that** the electrically conductive material is a bonding agent or toner.

8. Process according to Claim 7, **characterised in that** the electrically conductive material is introduced into the contact points by a screen printing process.

9. Circuit carrier having conditionable or conditioned contact points for the diversion of conductive paths from a first line grid (N) to conductive paths in another line grid, wherein the circuit carrier features two conductor track planes separated from each other by an electrically insulating layer, in particular a plastic film, **characterised in that** the electrically insulating layer features apertures, that conductor tracks (Le, Lw) of the said conductor track planes intersect each other in projection at the apertures, that conductor track parts of the said conductor track planes extend on both sides by means of the said apertures, that the said conductor track parts lying one above the other are or can be mechanically deformed, that mechanically deformed conductor track parts of a conductor track plane are electrically in contact with a conductor track part of the opposite lying conductor track plane and form conditionable or conditioned contact points (K) and that the said contact points present a shared interval (T) of the first line grid (N) in respect to each other, so that the diversion of the conductive paths from the first line grid into the conductive paths of the other line grid is effected by subsequently formable contact points.

10. Circuit carrier according to Claim 9, **characterised in that** the first line grid belongs to a first standard pin layout of integrated circuits and that the other line grid belongs to another standard pin layout of integrated circuits.

11. Circuit carrier according to Claim 9, characterised in that mechanically deformable and/or deformed conductor track parts are conductor track parts extending from the periphery of an aperture and are bent or can be bent into the aperture.

12. Circuit carrier according to one of Claims 9 or 11, characterised in that the deformed conductor trick parts are fixed in the contact position with electrically conductive material.

13. Circuit carrier according to Claim 12, characterised in that the contact points feature electrically conductive material introduced by screen printing.

14. Circuit carrier according to one of Claims 9 to 13, **characterised in that** the two conductor track planes each feature an arrangement of parallel running conductor tracks, wherein the conductor tracks of one of the planes are not parallel to the conductor tracks of the other plane and conditionable or conditioned contact points are arranged on at least one part of the intersections of the conductor tracks of the two planes.

15. Circuit carrier according to Claim 14, **characterised in that** the conductor track arrangement of the two conductor track planes are at an angle of 90° to one another.

## Revendications

1. Procédé de fabrication de zones de contact (K), dans lesquelles le contact peut être établi ultérieurement, situées entre deux plans de pistes conductives d'un support de circuits, séparées par une couche isolante électrique, en particulier une feuille en matière synthétique, caractérisé par la réalisation de trous au moins dans un plan de pistes conductives de telle sorte que la gravure ultérieure du substrat, par gravure sous-jacente, mette à nu, entre les trous ou dans les trous, des parties de pistes conductives en forme de barrettes communiquant avec la périphérie des trous, les barrettes étant orientées de telle sorte qu'elles relient, au niveau des ajours dans la projection, des pistes conductives (Lo, Lu) qui s'entrecroisent et de ce fait, les barrettes se superposent librement et, en cas de besoin, peuvent être contactées électriquement en les amenant les unes contre les autres.

2. Procédé selon la revendication 1, caractérisé en ce que dans l'un des plans des pistes conductives sont réalisés des trous qui correspondent avec le placage métallique sélectif de l'autre plan de pistes conductives avec une partie de piste conductive pénétrant dans le trou et communiquant avec la périphérie du trou, cette partie de piste conductive étant orientée de manière à couvrir dans la projection une zone conductive de l'autre plan de pistes conductives, et en ce que, au cours d'une autre étape, une gravure est réalisée à travers le trou dans la couche isolante entre les deux plans de pistes conductives, mettant ainsi à nu la partie de piste conductive au-dessus de la zone de contact correspondante et permettant d'établir le contact, en cas de besoin, dans ladite partie de piste conductive par pliage contre la zone de contact.

3. Procédé selon la revendication 1, caractérisé en ce que, pour établir le contact dans les zones de contact, les parties de pistes conductives opposées sont amenées les unes contre les autres par l'intermédiaire d'une fiche de contact et sont reliées pour former un conducteur électrique.

4. Procédé selon la revendication 1, caractérisé en ce que, pour établir le contact dans les zones de contact, l'espace mis à nu entre les barrettes est rempli par un matériau conducteur électrique.

5. Procédé selon la revendication 2, caractérisé en ce que, pour établir le contact dans les zones de contact, la partie de piste conductive du trou communiquant avec la périphérie du trou et pénétrant dans le trou, est pliée par pulvérisation de poudre ponce (jet-scrubbing) pour pénétrer dans l'ajour du substrat de la carte de circuits, afin d'entrer en contact avec la face opposée du placage métallique sélectif.

6. Procédé selon la revendication 5, caractérisé en ce que la partie de piste conductive repliée dans l'ajour est fixée avec un matériau conducteur.

7. Procédé selon la revendication 4 ou 6, caractérisé en ce que le matériau conducteur électrique est un adhésif ou un toner.

8. Procédé selon la revendication 7, caractérisé en ce que le matériau conducteur électrique est introduit dans les zones de contact par un processus de sérigraphie.

9. Support de circuits avec des zones de contact, qui peuvent être conditionnées ou sont conditionnées, destiné à dévier les circuits d'une première grille fondamentale de circuits (N) vers des circuits dans d'autres grilles fondamentales de circuits, le support de circuits étant muni de deux plans de pistes conductives séparées par une couche isolante électrique, en particulier une feuille de matière synthétique, caractérisé en ce que la couche isolante électrique contient des ajours, en ce que les pistes conductives (Lo, Lu) de ces plans de pistes conductives se croisent au niveau des ajours dans la projection, en ce que des parties de pistes conductives de ces plans de pistes conductives s'étendent de chaque côté au-delà de ces ajours, en ce que ces parties de pistes conductives au-dessus de ces ajours peuvent être formées et/ou sont formées par voie mécanique et se superposent, en ce que les parties de pistes conductives d'un plan de pistes conductives, formées par voie mécanique, peuvent être contactées ou sont contactées avec une partie de pistes conductives du plan de pistes conductives opposé et forment des zones de contact (K) qui peuvent être conditionnées ou qui sont conditionnées et en ce que ces zones de contact sont éloignées les unes des autres par un intervalle séparé (T) de la première grille fondamentale de circuits (N), de telle sorte que la déviation des circuits de la première grille fondamentale de circuits vers des circuits dans l'autre grille fondamentale de circuits est obtenue par l'intermédiaire des zones de contact réalisables ultérieurement.

10. Support de circuits selon la revendication 9, caractérisé en ce que la première grille fondamentale de circuits appartient à une première armature de broches normales de circuits intégrés et en ce que l'autre grille fondamentale de circuits appartient à une autre armature de broches normales de circuits intégrés.

11. Support de circuits selon la revendication 9, caractérisé en ce que les parties de pistes conductives qui peuvent être formées et/ou sont formées par voie mécanique sont des parties de pistes conductives qui peuvent être pliées ou sont pliées en partant de la périphérie d'un ajour jusque dans l'ajour.

12. Support de circuits selon la revendication 9 ou 11, caractérisé en ce que les parties de pistes conductives formées sont fixées en position de contact avec un matériau conducteur électrique.

13. Support de circuits selon la revendication 12, caractérisé en ce que les zones de contact contiennent des matériaux conducteurs électriques introduits par sérigraphie.

14. Support de circuits selon l'une quelconque des revendications 9 à 13, caractérisé en ce que les deux plans de pistes conductives sont formés chacun de pistes conductives disposées parallèlement, les pistes conductives de l'un des plans n'étant pas parallèles aux pistes conductives de l'autre plan, et des zones de contact qui peuvent être conditionnées ou sont conditionnées se situent sur au moins une partie des croisements entre les pistes conductives des deux plans.

15. Support de circuits selon la revendication 14, caractérisé en ce que les pistes conductives des deux plans de pistes conductives sont disposées de manière à former des angles de 90°.
